# EUROPEAN PATENT APPLICATION

(11) **EP 1 418 217 A1**
(43) Date of publication of application: **12.05.2004**
(21) Application number: 02730860.0
(22) Date of filing: 31.05.2002
(51) Int. Cl.: C09K 11/06, H05B 33/14, H05B 33/22, C07F 15/00

(54) **ORGANO-ELECTROLUMINESCENCE ELEMENT, LUMINESCENT MATERIAL AND ORGANIC COMPOUND**

(30) Priority: 04.06.2001 JP 2001167791; 29.05.2002 JP 2002155423
(71) Applicant: Sanyo Electric Co., Ltd., Moriguchi-shi, Osaka 570-8677 (JP)
(72) Inventor: MATSUSUE, Noriyuki c/o SANYO ELECTRIC CO., LTD., Moriguchi-shi, , Osaka 570-8677 (JP); HAMADA, Yuji c/o SANYO ELECTRIC CO., LTD., Moriguchi-shi, , Osaka 570-8677 (JP)
(74) Representative: Calderbank, Thomas Roger
(86) International application number: PCT/JP2002/005405
(87) International publication number: WO 2002/099008

(57) **Abstract**

In an organic EL device, a hole injection electrode is formed on a glass substrate, and a hole transport layer, a light emitting layer and a hole blocking layer are formed sequentially on the hole injection electrode. An electron transport layer is formed on the hole blocking layer, and an electron injection electrode is formed on the electron transport layer. The light emitting layer includes an organic platinum group element compound composed of a phenanthridine derivative and a platinum group element. This organic platinum group element compound can emit red-orange light via a triplet excited state.

## Description

### Technical Field

The present invention relates to an organic electroluminescent device, a light emitting material and an organic compound.

### Background Art

Organic electroluminescent devices (hereinafter referred to as organic EL devices) are expected as new self-light emitting devices. An organic EL device has a stacked layered structure that a carrier transport layer (an electron transport layer or a hole transport layer) and a light emitting layer are formed between a hole injection electrode and an electron injection electrode.

Electrode materials having a large work function such as gold or ITO (indium-tin oxide) are employed for the hole injection electrode, while those having a small work function such as Mg (magnesium) or Li (lithium) are employed for the electron injection electrode.

Organic materials are employed for the hole transport layer, the light emitting layer and the electron transport layer. Materials having the property of a p-type semiconductor are employed for the hole transport layer, while those having the property of an n-type semiconductor are employed for the electron transport layer. The light emitting layer also has carrier transportability such as electron transportability or hole transportability and is composed of organic materials emitting fluorescence or phosphorescence.

These hole injection electrode, hole transport layer, light emitting layer, electron transport layer and electron injection electrode are stacked sequentially to form the organic EL device.

Each function layer such as the hole transport layer, the electron transport layer and the light emitting layer may be constituted by a plurality of layers or omitted depending on the organic materials to be used.

In such an elementary structure as shown in Appl. Phys. Lett., Vol. 55, pp. 1489-1491 by Chihaya Adachi et al., for example, only two organic layers, which are a light emitting layer and an electron transport layer exist between a hole injection electrode and an electron injection electrode. This is because the light emitting layer composed of a light emitting material called NSD has excellent hole transportability and hence serves also as a hole transport layer.

Further, the elementary structure shown in Appl. Phys. Lett., Vol. 51, pp. 913-915 (1987) by C. W. Tang et al. is constituted by two organic layers, which are a hole transport layer and a light emitting layer. In this case, tris(8-hydroxyquinolinato)aluminum (hereinafter referred to as Alq) contained in the light emitting layer serves to both emit light and transport electrons.

On the other hand, the elementary structure shown in Appl. Phys. Lett., Vol. 69, pp. 2160-2162(1996) by S. A. Van Slyke et al. is constituted by three organic layers, which are a hole injection layer, a hole transport layer and a light emitting layer. In this case, the hole injection layer is composed of copper phthalocyanine, exhibiting the same function as the hole transport layer, which results in two hole transport layers existing in the entire device.

Thus, the number of the electron transport layers, hole transport layers and light emitting layers can freely be adjusted depending on the organic materials to be used.

In the organic EL devices, visible light of blue through red can be obtained by selecting the organic materials constituting the light emitting layers. Accordingly, a full-color display can be realized by use of organic EL devices that emit respective monochromatic lights of red, green and blue which are three primary colors (RGB) of light.

In red light, green light and blue light obtained from the organic EL devices, the green light and blue light are stable light. In contrast, as for red through orange light, i.e., red-orange light, it is difficult to obtain the light with high luminance and high luminous efficiency. This is because there exist no solid organic materials that emit fluorescence or phosphorescence of red to orange at high efficiency.

For example, as the organic materials for the light emitting layers of the organic EL devices that emit red-orange light, DCM-based materials being laser dye-based materials such as 4-(dicyanomethylene)-2-methyl-6-julodin-4-yl-vinyl)-4H-pyran (hereinafter referred to as DCM) and the like that has such a structure as represented mainly by a formula (13) shown below are employed. In such organic EL devices employing the DCM-based materials, however, luminous efficiency can hardly be increased.

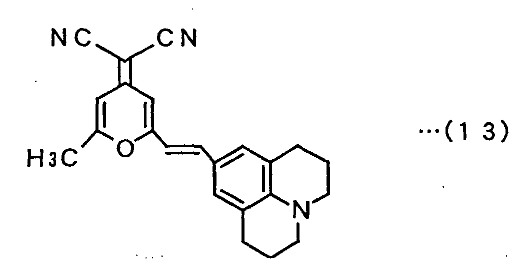

### Disclosure of the Invention

An object of the present invention is to provide an organic EL device in which red-orange light with high luminance can be obtained at high luminous efficiency.

Another object of the present invention is to provide a light emitting material in which red-orange light with high luminance can be obtained at high luminous efficiency.

Still another object of the present invention is to provide an organic compound in which red-orange light with high luminance can be obtained at high luminous efficiency.

An organic electroluminescent device according to one aspect of the present invention includes a hole injection electrode, an electron injection electrode, and a light emitting layer provided between the hole injection electrode and the electron injection electrode, wherein the light emitting layer includes a compound composed of a platinum group element and a phenanthridine derivative.

In the organic electroluminescent device according to the present invention, the light emitting layer includes a compound composed of a platinum group element and a phenanthridine derivative.

Since the compound composed of the platinum group element and the phenanthridine derivative is a material capable of emitting light via a triplet excited state, the light emitting layer of the above organic electroluminescent device can emit red-orange light by effectively utilizing the triplet excited state which cannot be effectively used in general.

Thus, it becomes possible to realize red-orange light emission with high luminance at high luminous efficiency in the above organic electroluminescent device.

In the above organic electroluminescent device, the light emitting layer per se may be composed of the compound comprised of a platinum group element and a phenanthridine derivative. Alternatively, a compound composed of a platinum group element and a phenanthridine derivative may be added as a dopant to the light emitting layer.

The platinum group element may be iridium, platinum, osmium, ruthenium, rhodium or palladium.

It is preferable that the compound composed of the platinum group element and the phenanthridine derivative has a molecular structure represented by a formula (1) below: 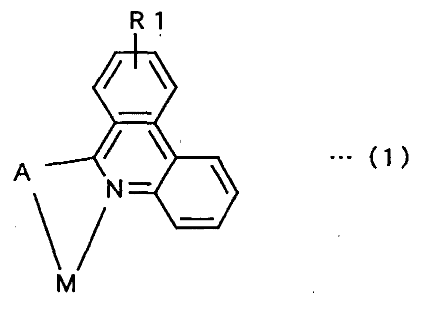 where R1 is a hydrogen atom, a halogen atom or a substituent, A is a substituent, and M is a platinum group element.

The light emitting layer comprised of the compound having such a molecular structure can emit red-orange light via the triplet excited state. This makes it possible to realize red-orange light emission with high luminance at high luminous efficiency.

In the compound represented by the formula (1), the A may have a molecular structure represented by a formula (A1) shown below: 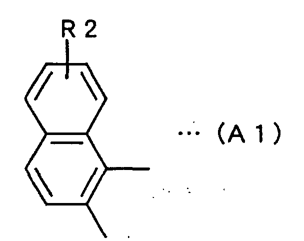 where R2 may be a hydrogen atom, a halogen atom or a substituent.

In the compound represented by the formula (1), the A may have a molecular structure represented by a formula (A2) shown below: 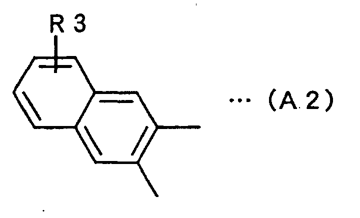 where R3 may be a hydrogen atom, a halogen atom or a substituent.

In the compound represented by the formula (1), the A may have a molecular structure represented by a formula (A3) shown below: 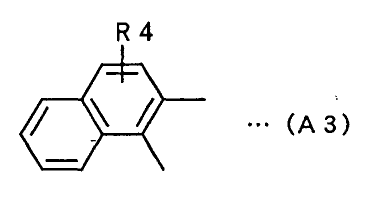 where R4 may be a hydrogen atom, a halogen atom or a substituent.

In the compound represented by the formula (1), the A may have a molecular structure represented by a formula (A4) shown below: 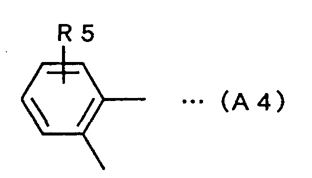 where R5 may be a hydrogen atom, a halogen atom or a substituent.

In the compound represented by the formula (1), the A may have a molecular structure represented by a formula (A5) shown below: 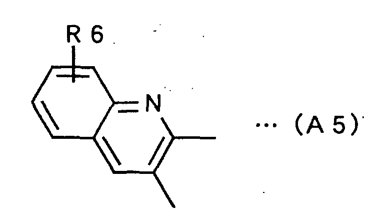 where R6 may be a hydrogen atom, a halogen atom or a substituent.

In the compound represented by the formula (1), the A may have a molecular structure represented by a formula (A6) shown below: 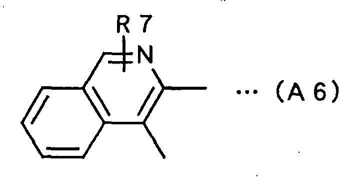 where R7 may be a hydrogen atom, a halogen atom or a substituent.

In the compound represented by the formula (1), the A may have a molecular structure represented by a formula (A7) shown below: 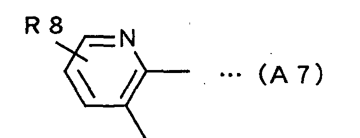 where R8 may be a hydrogen atom, a halogen atom or a substituent.

The compound composed of the platinum group element and the phenanthridine derivative may have a molecular structure represented by a formula (2) shown below: 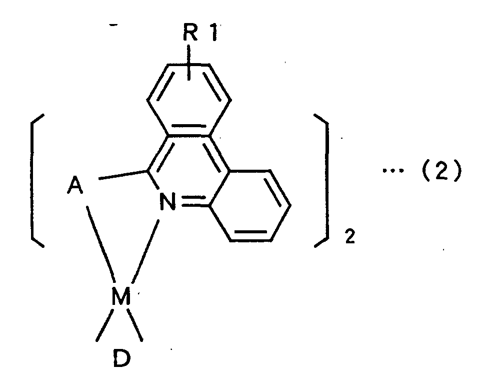 where R1 may be a hydrogen atom, a halogen atom or a substituent, A may be a substituent, M may be a platinum group element, and D may be a substituent forming a ring.

The D may have a molecular structure represented by a formula (D1) shown below: 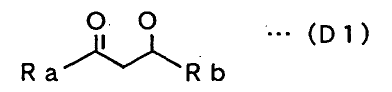 where Ra and Rb are the same or different and each may be a hydrogen atom, a halogen atom or a substituent.

The D may have a molecular structure represented by a formula (D2) shown below: 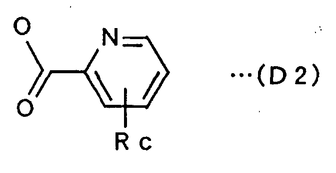 where Rc may be a hydrogen atom, a halogen atom or a substituent.

The compound composed of the platinum group element and the phenanthridine derivative may have a molecular structure represented by a formula (3) shown below: 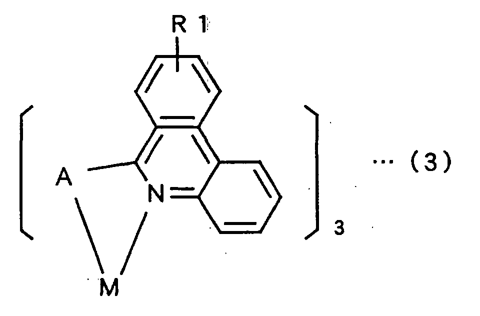 where R1 may be a hydrogen atom, a halogen atom or a substituent, A may be a substituent, and M may be a platinum group element.

The compound composed of the platinum group element and the phenanthridine derivative may have a molecular structure represented by a formula (C13) shown below:

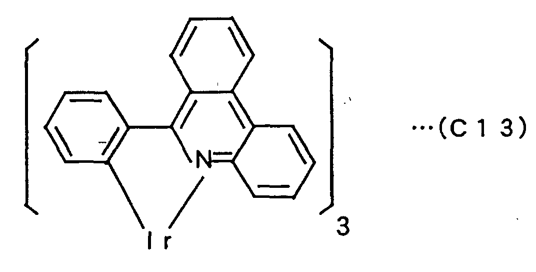

The compound composed of the platinum group element and the phenanthridine derivative may have a molecular structure represented by a formula (C10) shown below:

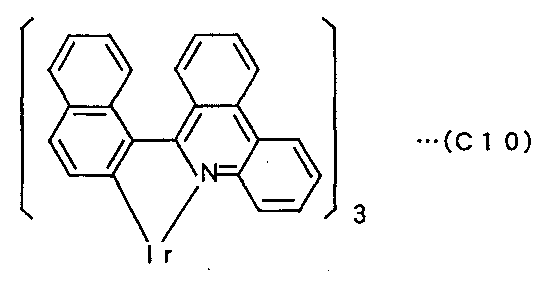

The light emitting layer may further include a host material, and the content of the compound composed of the platinum group element and the phenanthridine derivative may be not less than 0.1 wt% nor more than 50 wt% for the host material. Thus, even if the compound composed of the platinum group element and the phenanthridine derivative is added as a dopant to the light emitting layer, red-orange light with high luminance can be obtained at high luminous efficiency.

The host material may be 4,4'-bis(carbazol-9-yl)biphenyl having the molecular structure represented by a formula (12) shown below:

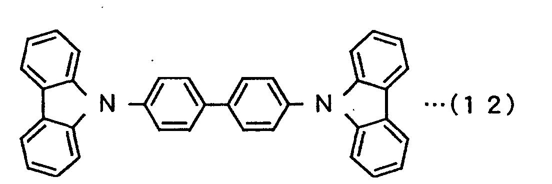

The use of such a host material allows the achievement of red-orange light with high luminance at high luminous efficiency.

The organic electroluminescent device may further include an electron transport layer provided between the light emitting layer and the electron injection electrode, and a hole blocking layer which is provided between the light emitting layer and the electron transport layer and has a larger ionization potential than that of the electron transport layer. The provision of such a hole blocking layer results in an increased energy barrier between the light emitting layer and the hole blocking layer. This makes it possible to prevent the injection of holes from the light emitting layer to the electron transport layer and thus re-couple electrons and holes at high efficiency in the light emitting layer. This enables the improved luminous efficiency of the organic electroluminescent device.

A light emitting material according to another aspect of the present invention has a molecular structure represented by a formula (1) shown below: 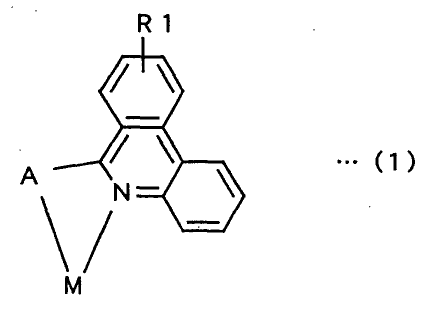 where R1 is a hydrogen atom, a halogen atom or a substituent, A is a substituent, and M is a platinum group element.

The light emitting material may have a molecular structure represented by a formula (2) shown below: 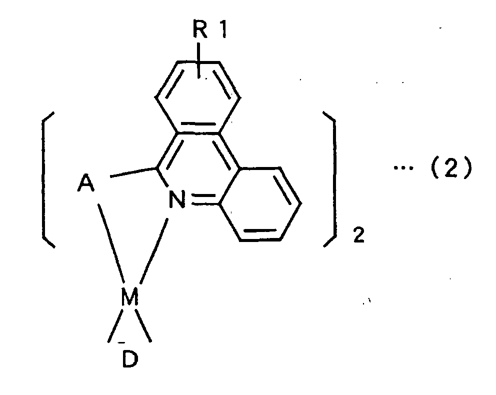 where R1 may be a hydrogen atom, a halogen atom or a substituent, A may be a substituent, M may be a platinum group element, and D may be a substituent forming a ring.

The D may have a molecular structure represented by a formula (D1) shown below: 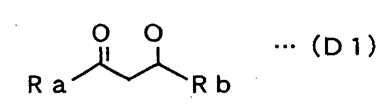 where Ra and Rb are the same or different and each may be a hydrogen atom, a halogen atom or a substituent.

The D may have a molecular structure represented by a formula (D2) shown below: 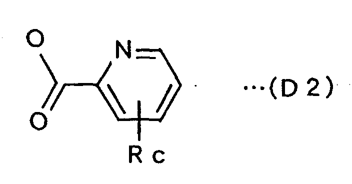 where Rc may be a hydrogen atom, a halogen atom or a substituent.

The light emitting material may have a molecular structure represented by a formula (3) shown below: 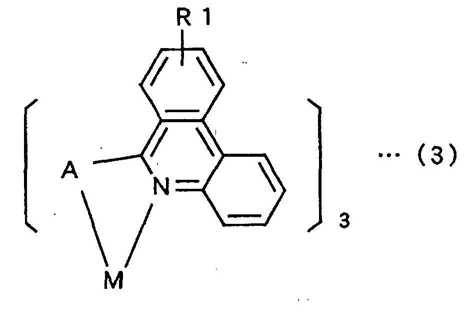 where R1 may be a hydrogen atom, a halogen atom or a substituent, A may be a substituent, and M may be a platinum group element.

Such a light emitting material can emit red-orange light since it is such a material that can emit light via a triplet excited state.

An organic compound according to still another aspect of the present invention has a molecular structure represented by a formula (2) shown below: 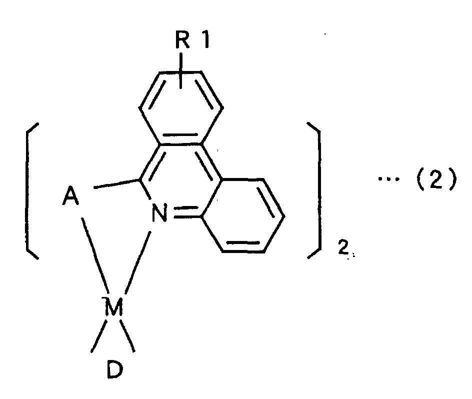 where R1 is a hydrogen atom, a halogen atom or a substituent; A is a substituent, M is a platinum group element, and D is a substituent forming a ring.

The D may have a molecular structure represented by a formula (D1) shown below: 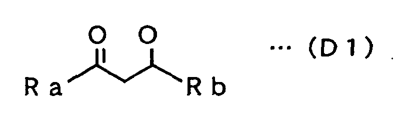 where Ra and Rb are the same or different and each may be a hydrogen atom, a halogen atom or a substituent.

The D may have a molecular structure represented by a formula (D2) shown below: 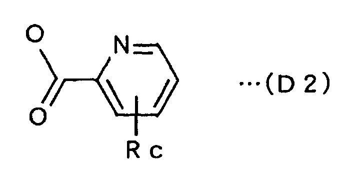 where Rc may be a hydrogen atom, a halogen atom or a substituent.

An organic compound according to still further aspect of the present invention has a molecular structure represented by a formula (3) shown below: 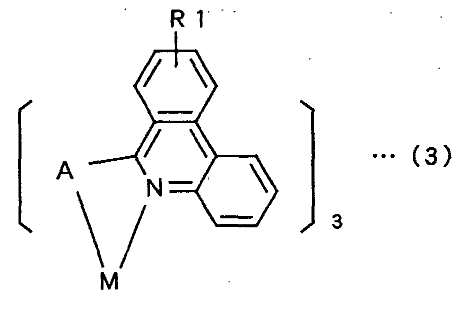 where R1 is a hydrogen atom, a halogen atom or a substituent, A is a substituent, and M is a platinum group element.

The organic compound may have a molecular structure represented by a formula (C1) shown below:

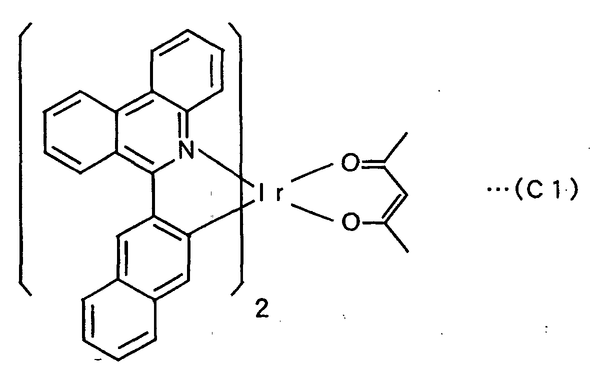

The organic compound may have a molecular structure represented by a formula (C2) shown below:

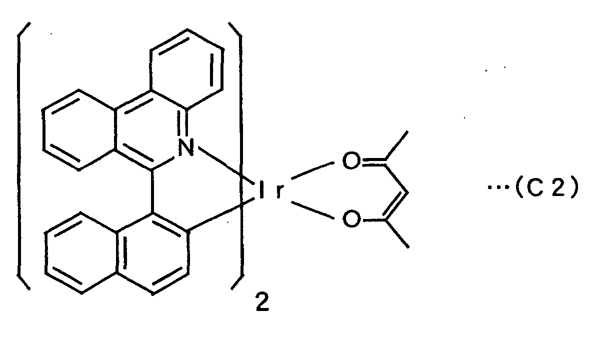

The organic compound may have a molecular structure represented by a formula (C3) shown below:

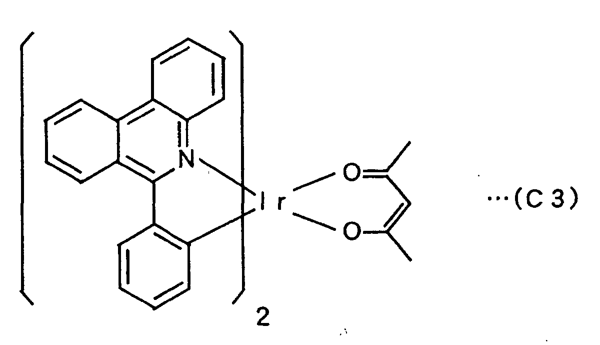

The organic compound may have a molecular structure represented by a formula (C4) shown below:

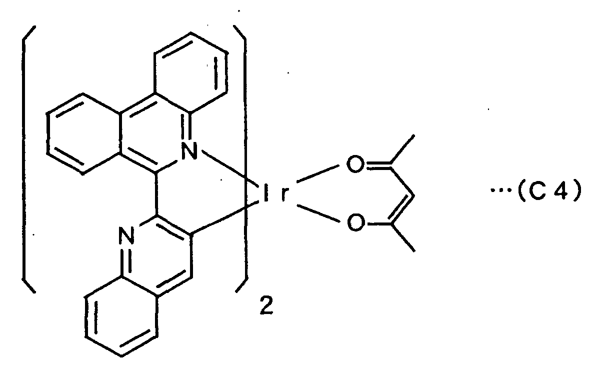

The organic compound may have a molecular structure represented by a formula (C5) shown below:

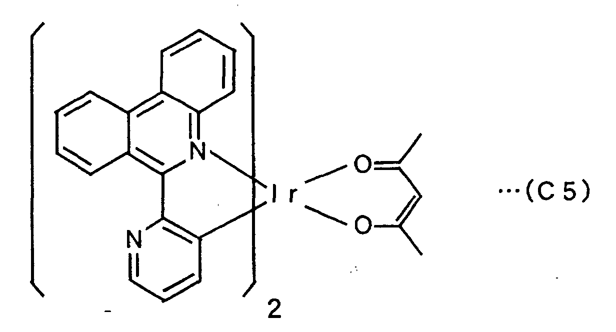

The organic compound may have a molecular structure represented by a formula (C6) shown below:

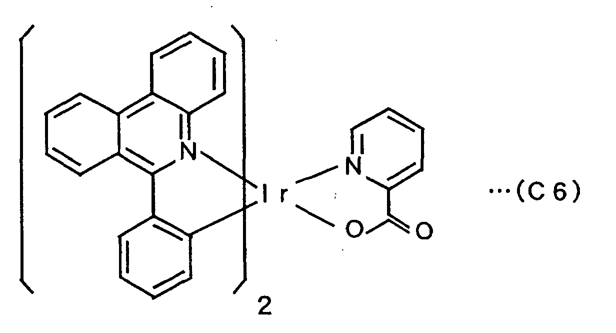

The organic compound may have a molecular structure represented by a formula (C7) shown below:

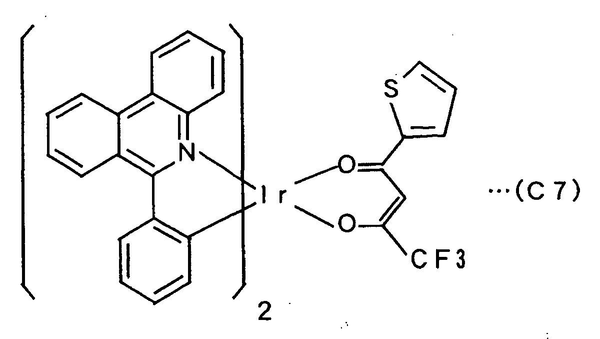

The organic compound may have a molecular structure represented by a formula (C8) shown below:

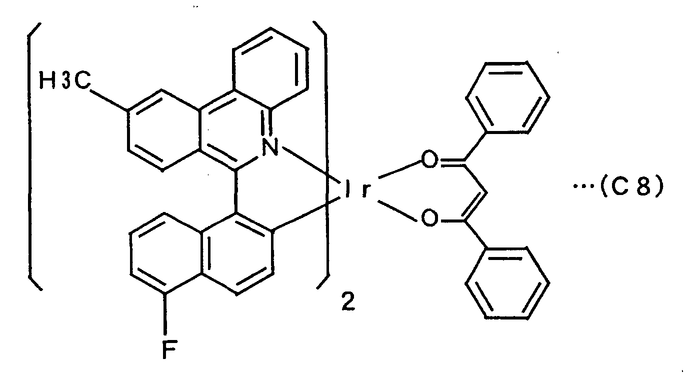

The organic compound may have a molecular structure represented by a formula (C9) shown below:

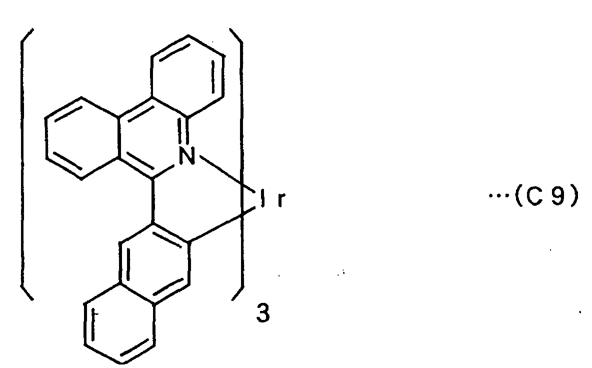

The organic compound may have a molecular structure represented by a formula (C10) shown below:

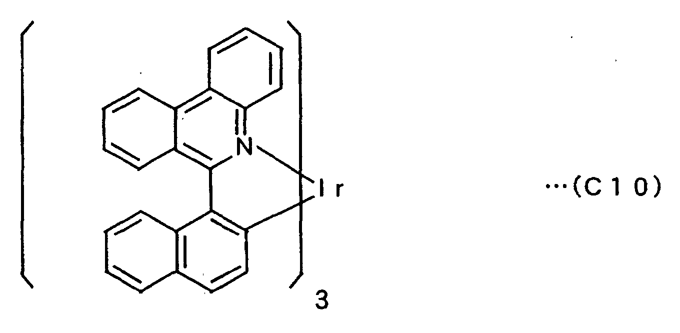

The organic compound may have a molecular structure represented by a formula (C11) shown below:

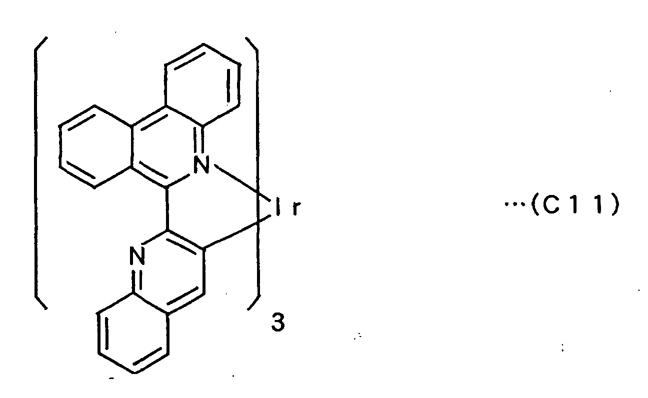

The organic compound may have a molecular structure represented by a formula (C12) shown below:

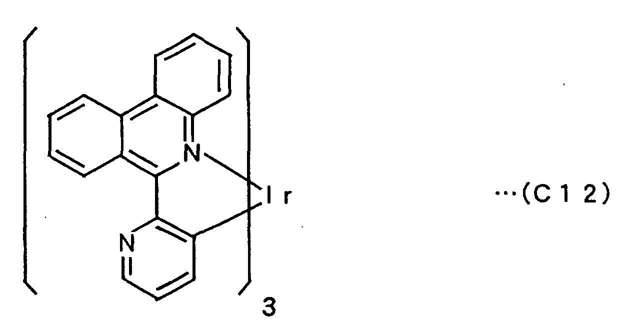

The organic compound may have a molecular structure represented by a formula (C13) shown below:

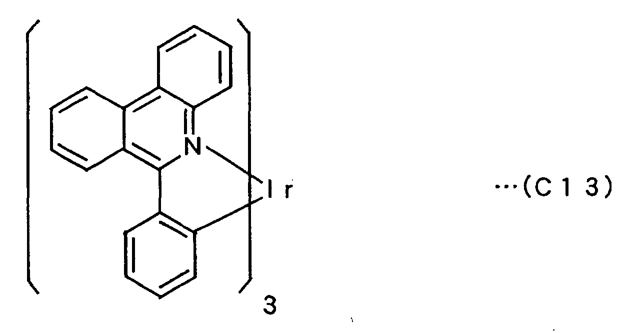

### Brief Description of the Drawings

Fig. 1 is a schematic diagram showing the structure of an organic EL device according to one embodiment of the present invention.
Fig. 2 is a diagram showing a photoluminescent spectrum of Ir(Ph-Phen)₃.

### Best Mode for Carrying out the Invention

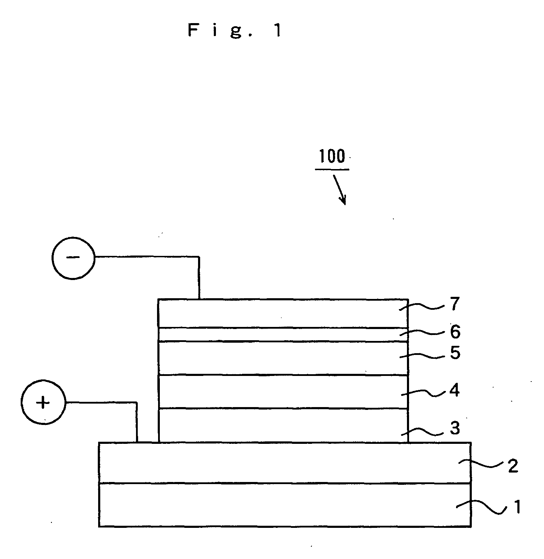

Fig. 1 is a schematic diagram showing the structure of an organic electroluminescent device (hereinafter referred to as an organic EL device) according to one embodiment of the present invention.

With reference to Fig. 1, a hole injection electrode (an anode) 2 composed of a transparent electrode film is formed on a glass substrate 1, in an organic EL device 100. A hole transport layer 3 and a light emitting layer 4 both made of respective organic materials are formed sequentially on the hole injection electrode 2. A hole blocking layer 5 made of an organic material is formed on the light emitting layer 4, an electron transport layer 6 is formed on the hole blocking layer 5, and an electron injection electrode (a cathode) 7 is formed on the electron transport layer 6.

The light emitting layer 4 includes an organic platinum group element compound composed of a phenanthridine derivative and an element of the platinum group being metal. The light emitting layer 4 per se may be composed of such an organic platinum group element compound, and alternatively, it may include such an organic platinum group element compound as a luminescent dopant.

In this embodiment, for example, the organic platinum group element compound composed of the platinum group element and the phenanthridine derivative is contained as the luminescent dopant in a host material which will be described later. The content of this organic platinum group element compound in this case is 0.1 wt% to 50 wt%, preferably 1 wt% to 10 wt% for the host material.

As the host material, 4,4'-bis(carbazol-9-yl)biphenyl (hereinafter referred to as CBP) having the molecular structure represented by, e.g., a formula (12) shown below is employed.

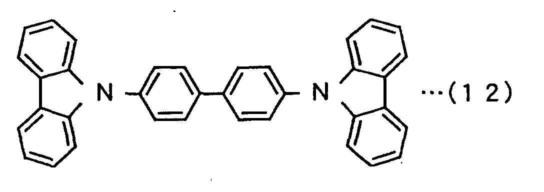

It is preferable that the above described organic platinum group element compound contained in the light emitting layer 4 has such a molecular structure as represented by a formula (1) shown below: 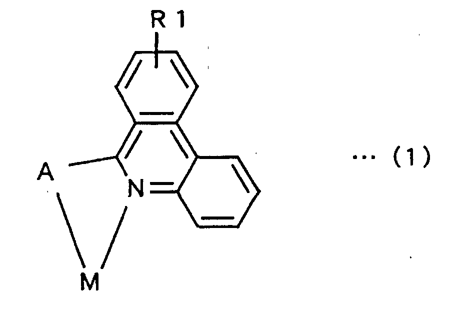 where R1 represents a hydrogen atom, a halogen atom or a substituent, A represents a substituent which will be described later, and M represents an element of the platinum group which will also be described later.

For example, R1 is -CₙH₂ₙ₊₁ (n = 0 to 10), a phenyl group, a naphthyl group, a thiophene group, -CN, -N(CₙH₂ₙ₊₁)₂ (n = 1 to 10), -COOCₙH₂ₙ₊₁ (n = 1 to 10), -F, -Cl, -Br, -I, -OCH₃, -OC₂H₅ or the like.

In the above formula (1), M is, for example, iridium (Ir), platinum (Pt), osmium (Os), ruthenium (Ru), rhodium (Rh) or palladium (Pd). In particular, M is preferably iridium or platinum. This makes it possible to achieve red-orange light with higher luminance at higher luminous efficiency.

In the above formula (1), A may be a substituent having a molecular structure represented by, for example, a formula (A1), (A2), (A3), (A4), (A5), (A6) or (A7) shown below:

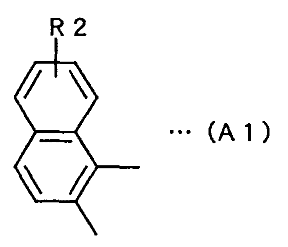

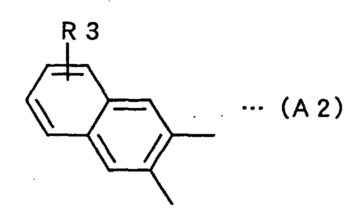

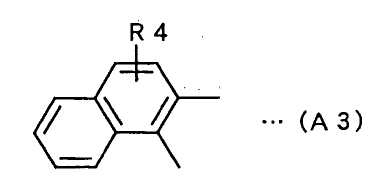

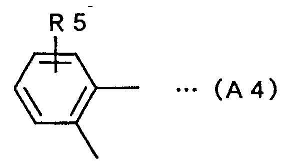

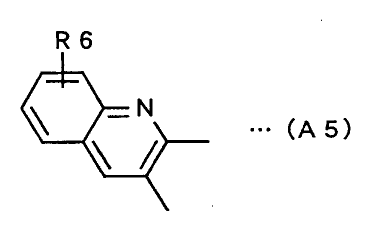

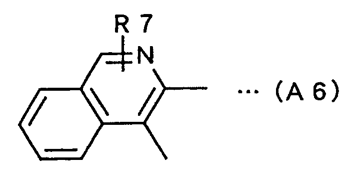

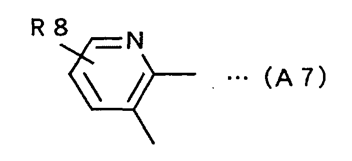

In the above formulas (A1) to (A7), R2 to R8 are each a hydrogen atom, a halogen atom or a substituent. For example, R2 to R8 are each -CₙH₂ₙ₊₁ (n = 0 to 10), a phenyl group, a naphthyl group, a thiophene group, -CN, -N(CₙH₂ₙ₊₁)₂ (n = 1 to 10), -COOCₙH₂ₙ₊₁ (n = 1 to 10), -F, -Cl, -Br, -I, -OCH₃, -OC₂H₅ or the like.

The organic platinum group element compound which is thus composed of the platinum group element and the phenanthridine derivative and has the structure represented by the above formula (1) can emit red-orange phosphorescence via a triplet excited state.

In particular, it is more preferable that the above-described organic platinum group element compound contained in the light emitting layer 4 has such a molecular structure as represented by a formula (2) shown below: 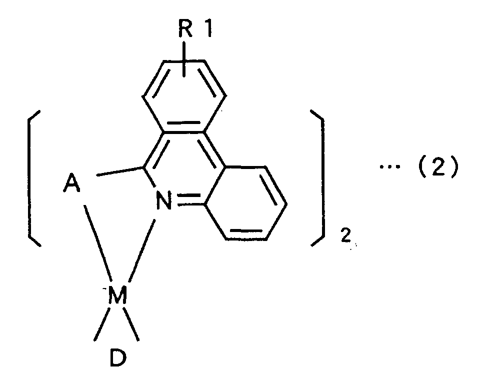 where R1 represents a hydrogen atom, a halogen atom or the same substituent as R1 in the formula (1), A represents the same substituent as A in the formula (1), M represents the same platinum group element as M in the formula (1), and D represents a substituent having a ring. For example, the compound of the formula (2) is comprised of the platinum group element, the phenanthridine derivative and an acetylacetone derivative.

In the formula (2), D may have a molecular structure represented by a formula (D1) shown below:

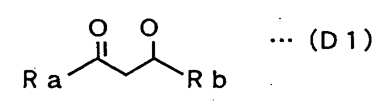

The D in the formula (2) may have a molecular structure represented by a formula (D2) shown below:

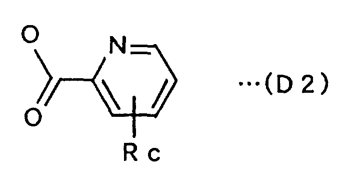

In the formulas (D1) and (D2), Ra, Rb and Rc are each a hydrogen atom, a halogen atom or a substituent. For example, Ra, Rb and Rc are each -CₙH₂ₙ₊₁ (n = 0 to 10), a phenyl group, a naphthyl group, a thiophene group, a furyl group, a thienyl group, -CN, -N(CₙH₂ₙ₊₁)₂ (n = 1 to 10), -COOCₙH₂ₙ₊₁ (n = 1 to 10), -F, -Cl, -Br, -I, -CF₃, -OCH₃, -OC₂H₅ or the like.

Alternatively, it is preferable that the above-described organic platinum group element compound contained in the light emitting layer 4 has a molecular structure represented by a formula (3) shown below: 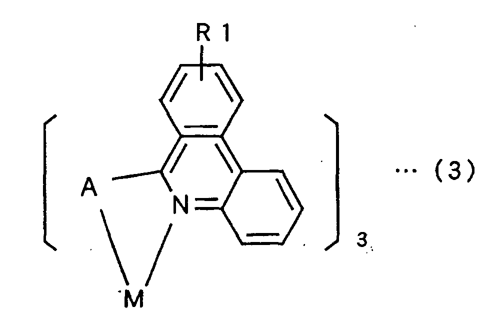 where R1 represents a hydrogen atom, a halogen atom or the same substituent as R1 in the formula (1), A represents the same substituent as A in the formula (1), and M represents the same platinum group element as M in the formula (1).

The organic platinum group element compound represented by the above formula (2) is produced by reacting a phenanthridine derivative having a molecular structure represented by a formula (B1) shown below, a platinum group element compound and a compound corresponding to D represented by the above formula (D1) or (D2), and then coordinating or chelating the phenanthridine derivative and D with the platinum group element. In this case, 1.5 to 2.5 mol of the phenanthridine derivative and 0.5 to 1.5 mol of the compound corresponding to D are reacted for 1 mol of the platinum group element compound. As the platinum group compound, tris(acetylacetonato)iridium (Ir(acac)₃), or iridium chloride or the like can be employed. Here, "acac" is an abbreviation of "acetylacetone."

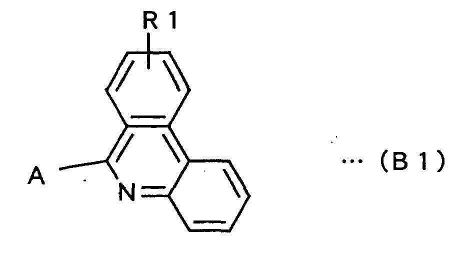

The organic platinum group element compound represented by the above formula (3) is produced by reacting the phenanthridine derivative having the molecular structure represented by the above formula (B1) and a platinum group element compound and then coordinating or chelating the phenanthridine derivative with the platinum group element. In this case, not less than 3 mol of the phenanthridine derivative is reacted for 1 mol of the platinum group element compound. As the platinum group element compound, tris(acetylacetonato)iridium (Ir(acac)₃), or iridium chloride or the like can be employed. Here, "acac" is an abbreviation of "acetylacetone."

For example, as the organic platinum group element compound contained in the light emitting layer 4, an organic iridium compound composed of iridium and a phenanthridine derivative, represented by a formula (C13) shown below may be employed:

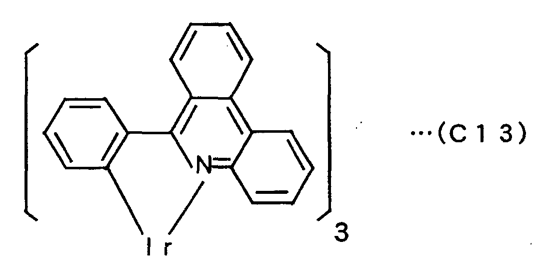

Alternatively, as the organic platinum group element compound contained in the light emitting layer 4, an organic iridium compound composed of iridium and a phenanthridine derivative, represented by a formula (C10) shown below may be employed:

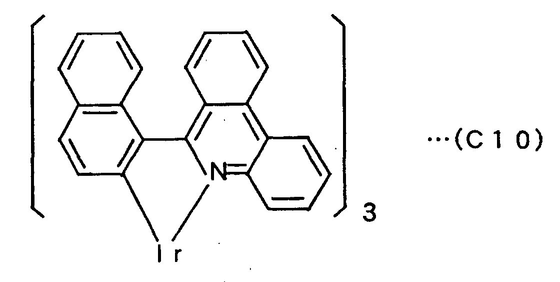

According to quantum mechanical studies, it is considered that out of the entire excited state caused by coupling of electrons and holes, the triplet excited state where electron spin is parallel is generated at a ratio of approximately 3/4, while the singlet excited state where electron spin is reverse parallel and the sum of spin quantum numbers is 0 is generated at a ratio of approximately 1/4.

The light emission, which is caused when electrons being in the singlet excited state out of such two types of excited states transit to a ground state, is called fluorescence. Such fluorescence is generated based on a spin allowable state and easily occurs. Thus, the fluorescence is widely utilized in luminescent phenomena such as of organic EL devices and the like.

On the other hand, the light emission, which is caused when electrons being in the triplet excited state transit to the ground state, is called phosphorescence. The phosphorescence is generated based on a spin inhibited state. According to Pauli's exclusion principle, it is not possible that two electrons with parallel electron spin exist on the same electron orbit (which corresponds to the ground state in this case). Therefore, the electron spin of the transiting electrons is required to be inverted by receiving some perturbation, in order that the electrons being in the triplet excited state transit to the ground state and emit light. However, the inversion of electron spin is difficult in most of luminescent substances which are usually used for the organic EL devices. Therefore, as for normal substances, phosphorescence is known as a special phenomenon which is observed only in a very low temperature area equal to or below a liquid nitrogen temperature.

For example, the above described DCM-based material employed as light emitting materials for a conventional red light emitting organic EL device emits red fluorescence via the singlet excited state, and thus this material cannot effectively utilize the triplet excited state covering approximately 3/4 of the entire excited state. It is therefore difficult to achieve the increased luminous efficiency in the organic EL device having the light emitting layer made of such DCM-based red light emitting materials.

In contrast, in the organic EL device 100 of this embodiment, as described above, since the light emitting layer 4 includes, as the red-orange light emitting materials, the organic platinum group element compound having the structure represented by the above formula (1), the light emitting layer 4 can emit red-orange phosphorescence via the triplet excited state. Thus, it is possible to effectively use the triplet excited state covering approximately 3/4 of the entire excited state, in this case. This makes it possible to obtain red-orange light with high luminance at high luminous efficiency in the organic EL device 100.

M. A. Bald et al. disclose in Applied Physics Letters, Vol. 75, No. 1, p. 4 (1999) an organic iridium compound having a molecular structure represented by a formula (14) shown below:

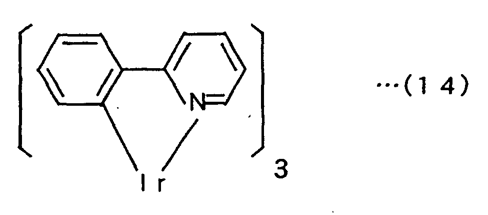

The disclosed organic iridium compound is, however, a compound comprised of a combination of phenylpyridine and iridium, and hence its π conjugated electron system is shorter than that of the compound comprised of the combination of a phenanthridine derivative and an element of the platinum group as in this embodiment. Therefore, the color of light emitted from the organic iridium compound composed of phenylpyridine and iridium disclosed in the above document is green.

On the other hand, in this embodiment, since the organic platinum group element compound composed of the combination of the phenanthridine derivative and the platinum group element is employed, its π conjugated electron system can be extended compared to that of the above compound composed of phenylpyridine and iridium. This makes it possible to shift a spectrum to a red-orange area, thereby realizing the organic EL device capable of emitting red-orange light in this embodiment.

The structure of the organic EL device according to the present invention is not limited to the above structure, but can employ various structures. For example, such a structure may be applied that only two layers, which are the light emitting layer and the electron transport layer are provided between the hole injection electrode 2 and the electron injection electrode 7. Alternatively, such a structure may be applied that the hole transport layer, the light emitting layer, the hole blocking layer and the electron transport layer are stacked in turn between the hole injection electrode 2 and the electron injection electrode 7.

A hole blocking layer having a larger ionization potential than that of the electron transport layer is preferably provided between the light emitting layer and the electron transport layer in the organic EL device. Provision of this hole blocking layer enables the increased energy barrier between the light emitting layer and the hole blocking layer. This can prevent the injection of holes from the light emitting layer to the layers on the side of the electron injection electrode (e. g., the electron transport layer and the electron injection layer), enabling the re-coupling of holes and electrons in the light emitting layer at high efficiency. This results in the improved luminous efficiency in the organic EL device.

In the above organic EL device 100, when voltage is applied across the hole injection electrode 2 and the electron injection electrode 7, the light emitting layer 4 emits red-orange light, and light is emitted from the back face of the glass substrate 1.

### [Examples]

Respective organic EL devices of inventive examples and a comparative example were manufactured, and their luminescent characteristics were measured as in the following.

### [Inventive Example A]

In the inventive example A, such an organic EL device was used that a hole injection electrode (an anode), a hole transport layer, a light emitting layer, a hole blocking layer, an electron transport layer and an electron injection electrode (a cathode) were stacked in turn on a glass substrate.

In this case, the hole injection electrode of organic EL device is composed of indium-tin oxides (ITO) of 1000 Å in thickness. The hole transport layer has a 500 Å thickness and is composed of N,N'-Di(naphthalen-1-yl)-N,N'-diphenylbenzidine (hereinafter referred to as NPB) having a molecular structure represented by a formula (15) shown below:

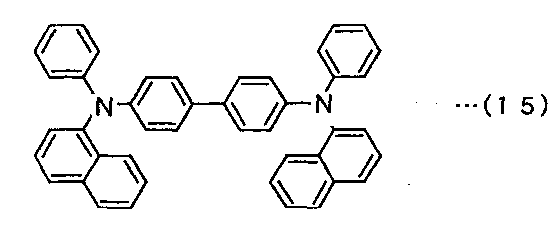

The light emitting layer 4 has a 200 Å thickness, and it contains CBP, as a host material, having a molecular structure represented by a formula (12) shown below, and contains, as a red-orange luminescent dopant, an organic iridium compound comprised of iridium and a phenylphenanthridine derivative having a molecular structure represented by a formula (C13) shown below (hereinafter referred to as Ir(Ph-Phen)₃). This Ir(Ph-Phen)₃ can emit red-orange light via the triplet excited state.

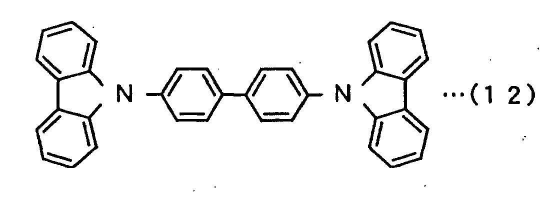

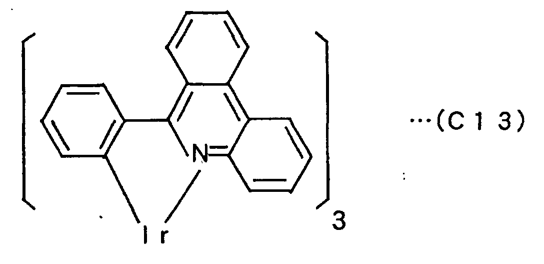

In this instance, the light emitting layer 4 contains 6.5 wt% of Ir(Ph-Phen)₃ for the CBP serving as the host material. Further, the ionization potential of CBP being the host material is 5.9 eV.

The hole blocking layer has a 100 Å thickness and is composed of Bathocuproine (hereinafter referred to as BCP) having a molecular structure represented by a formula (16) shown below. The ionization potential of the hole blocking layer composed of such BCP is 6.2 eV, which is larger than that of CBP serving as the host material of the light emitting layer. above is formed between the light emitting layer and the electron transport layer. This can prevent the injection of holes from the light emitting layer to the electron transport layer. This enables the re-coupling of holes and electrons in the light emitting layer at high efficiency. This results in the improved luminous efficiency in the organic EL device.

Further, the electron injection electrode is composed of a MgIn alloy (a ratio of 10 to 1) with a 2000 Å thickness.

The organic EL device having the above-described structure was manufactured as follows.

First, the hole injection electrode made of indium-tin oxides (ITO) was formed on the glass substrate. Then, the glass substrate with the hole injection electrode formed thereon was cleaned with a neutral detergent, followed by ultrasonic cleaning in acetone for ten minutes and in ethanol for ten minutes. Further, the surface of the glass substrate was cleaned in an ozone cleaner.

After that, the hole transport layer, the light emitting layer, the hole blocking layer, the electron transport layer and the electron injection electrode were stacked in turn by a vacuum vapor deposition on the above hole injection electrode made of ITO. Each vapor deposition was conducted on condition of ordinary temperature without control of substrate temperature at the degree of vacuum of 1 x 10⁻⁶ Torr.

A positive bias voltage was applied to the hole injection above is formed between the light emitting layer and the electron transport layer. This can prevent the injection of holes from the light emitting layer to the electron transport layer. This enables the re-coupling of holes and electrons in the light emitting layer at high efficiency. This results in the improved luminous efficiency in the organic EL device.

Further, the electron injection electrode is composed of a MgIn alloy (a ratio of 10 to 1) with a 2000 Å thickness.

The organic EL device having the above-described structure was manufactured as follows.

First, the hole injection electrode made of indium-tin oxides (ITO) was formed on the glass substrate. Then, the glass substrate with the hole injection electrode formed thereon was cleaned with a neutral detergent, followed by ultrasonic cleaning in acetone for ten minutes and in ethanol for ten minutes. Further, the surface of the glass substrate was cleaned in an ozone cleaner.

After that, the hole transport layer, the light emitting layer, the hole blocking layer, the electron transport layer and the electron injection electrode were stacked in turn by a vacuum vapor deposition on the above hole injection electrode made of ITO. Each vapor deposition was conducted on condition of ordinary temperature without control of substrate temperature at the degree of vacuum of 1 x 10⁻⁶ Torr.

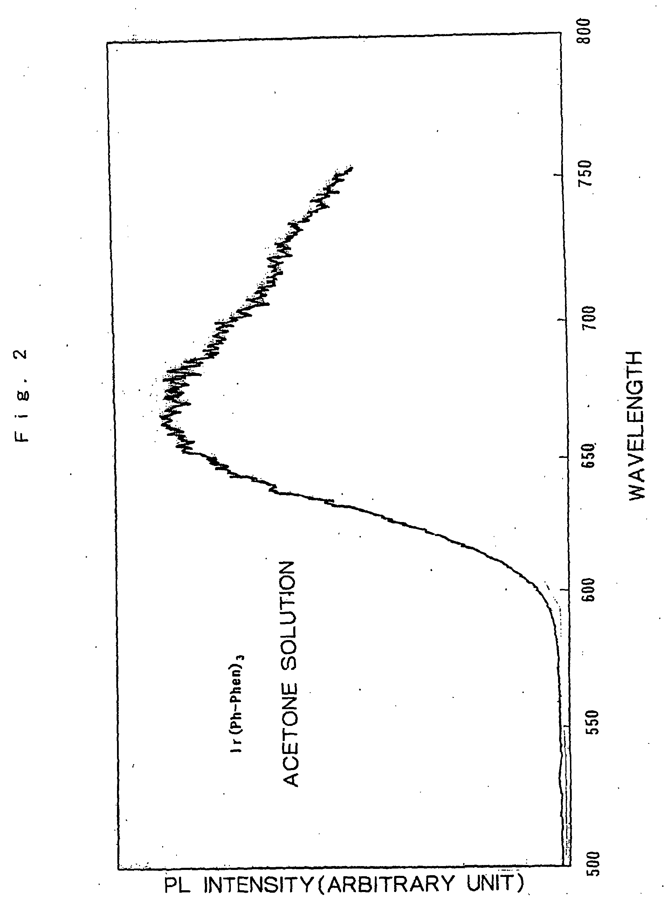

A positive bias voltage was applied to the hole injection electrode of the organic EL device manufactured by the above method, while a negative bias voltage was applied to the electron injection electrode, for measuring the luminescent characteristics of the device. Fig. 2 is a diagram showing a photoluminescence (PL) spectrum of Ir(Ph-Phen)₃.

The photoluminescence spectrum of Ir(Ph-Phen)₃ has a peak at a 650 nm wavelength as shown in Fig. 2.

In this case, the maximum luminance of the organic EL device was 10,200 cd/m², and the luminous efficiency at this time was 6 cd/A. Further, red emission was obtained in this organic EL device.

### [Comparative Example]

In the comparative example, an organic EL device was employed that has the same structure as that of the inventive example A except that as the red-orange luminescent dopant of the light emitting layer, Ir(Ph-Phen)₃ was replaced by 5,10,15,20-Tetraphenyl-21H,23H-porphine (hereinafter referred to as TPP) having a structure represented by a formula (18) shown below. This organic EL device of the comparative example was manufactured by the same method as applied to the organic EL device of the inventive example A. The TPP contained as the red-orange luminescent dopant in the light emitting layer is a substance that emits red-orange light via the singlet excited state.

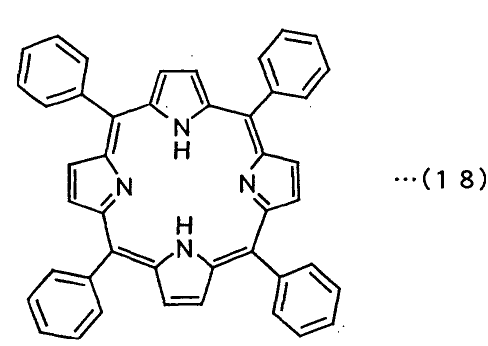

As for the above organic EL device, its luminescent characteristics were measured by the same method as applied to the inventive example A. As a result, red emission with a peak at a 645 nm wavelength was obtained in this organic EL device. The maximum luminance obtained in this case was 100 cd/m², and the luminous efficiency at this time was 0.1 cd/A.

As has been described above, it was apparent from the above inventive example A and comparative example that the red emission with high luminance was accomplished at excellent luminous efficiency in the organic EL device by use of Ir(Ph-Phen)₃, which is the triplet excited material as the red-orange luminescent dopant of the light emitting layer.

### [Inventive Examples 1 to 13]

In the inventive examples 1 to 13, such organic EL devices were employed that each has the same structure as that of the organic EL device of the inventive example A except for the dopant of the light emitting layer. The organic EL devices of the inventive examples 1 to 13 were manufactured by the same method as applied to the organic EL device of the inventive example A. Although the organic El device of the inventive example 13 has the same structure as that of the organic EL device of the inventive example A, it was manufactured at a different time from the organic EL device of the inventive example A.

As the dopants of the light emitting layers included in the respective organic EL devices of the inventive examples 1 to 13, respective compounds 1 to 13 having the molecular structures represented by the following formulas (C1) to (C13), respectively, were employed:

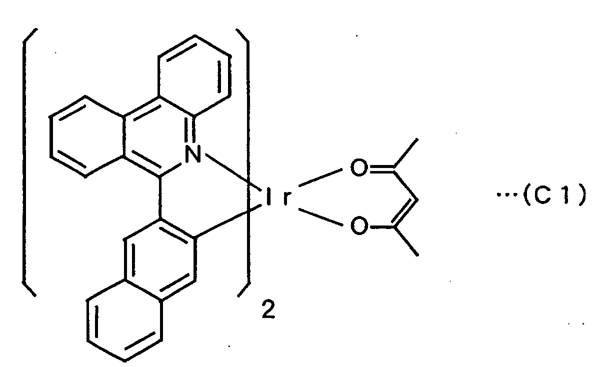

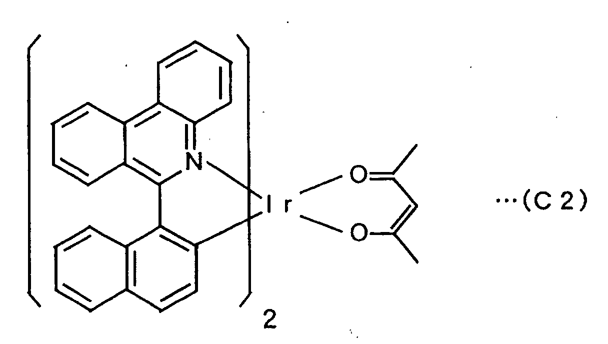

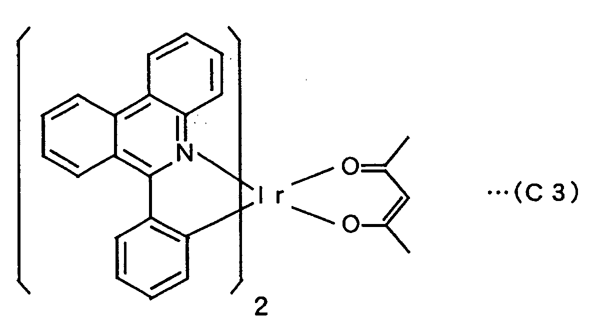

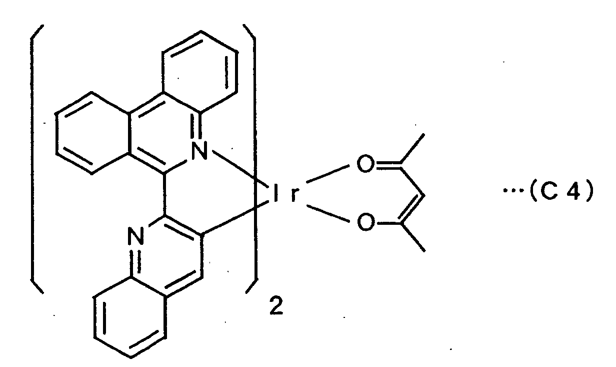

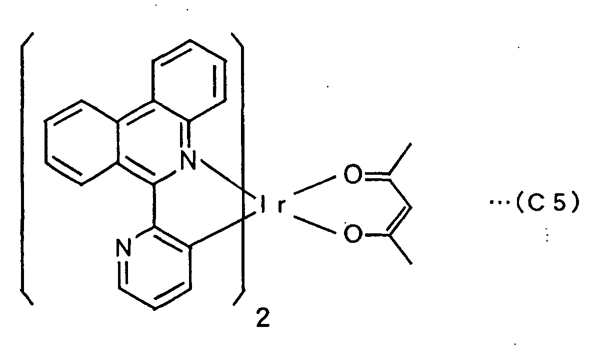

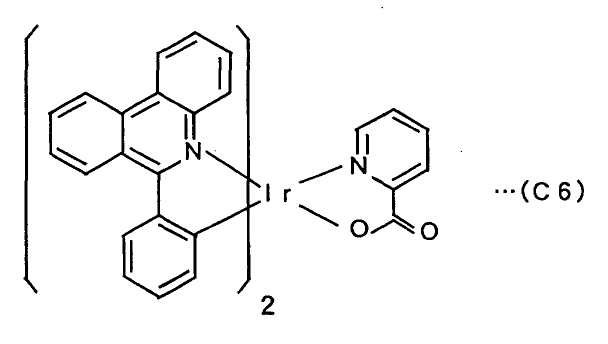

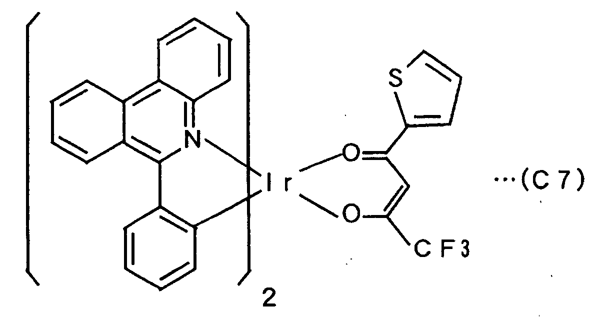

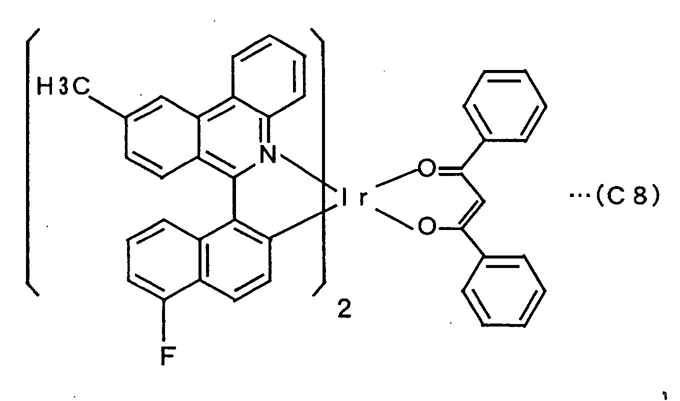

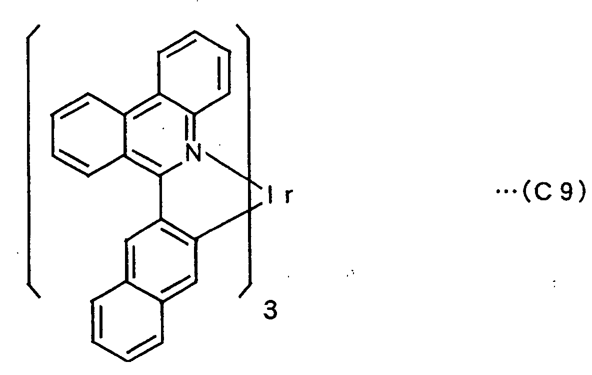

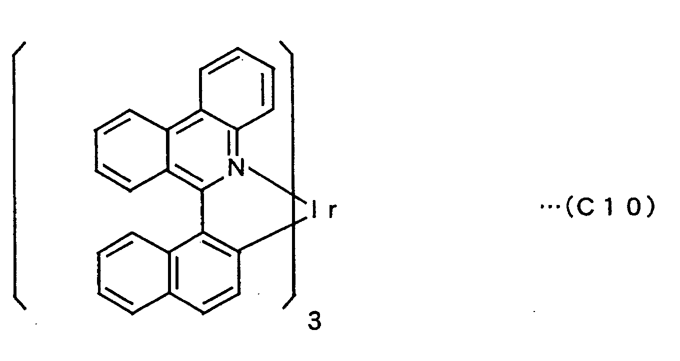

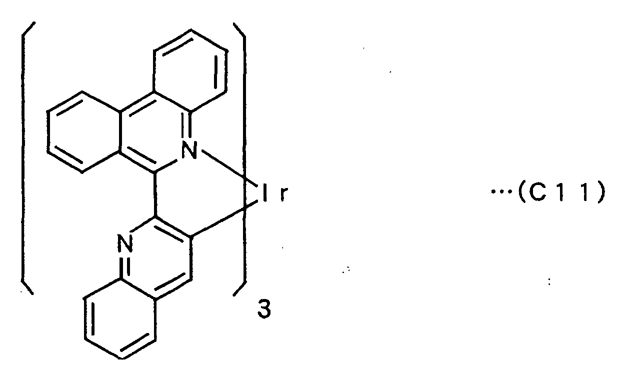

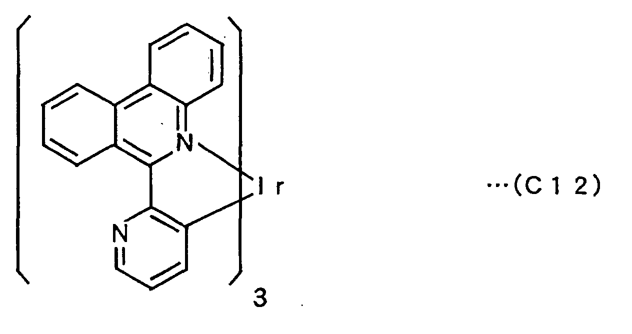

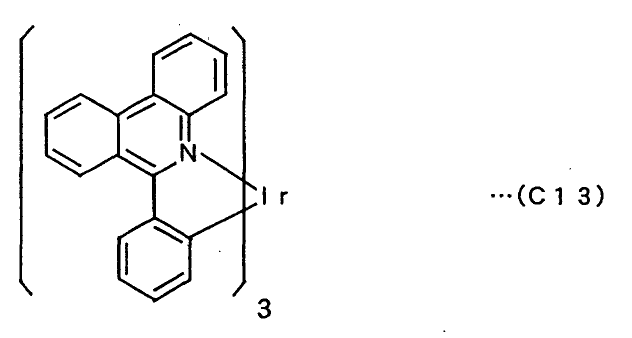

Table 1 shows the results of measurement of the materials and the luminescent characteristics of the organic EL devices in the inventive examples 1 to 13.

**(Table 1)**

| | Anode | Hole Transport Layer | Light Emitting Layer | Hole Blocking Layer | Electron Transport Layer | Cathode | Maximum Luminance (cd/m²) | Luminous Efficiency (cd/A) | Emission Wavelength (nm) | Chromaticity Coordinate (x,y) |
|---|---|---|---|---|---|---|---|---|---|---|
| Inventive Example 1 | ITO | NPB | CBP(host)+ 6.5%compound1 (dopant) | BCP | Alq | MgIn | 11,500 | 6.7 | 652 | 0.66,0.33 |
| Inventive Example 2 | ITO | NPB | CBP(host)+ 6.5%compound2 (dopant) | BCP | Alq | MgIn | 9,900 | 5.4 | 660 | 0.67,0.32 |
| Inventive Example 3 | ITO | NPB | CBP(host)+ 6.5%compound3 (dopant) | BCP | Alq | MgIn | 11,000 | 6.5 | 651 | 0.66,0.33 |
| Inventive Example 4 | ITO | NPB | CBP(host)+ 6.5%compound4 (dopant) | BCP | Alq | MgIn | 9,800 | 5.8 | 651 | 0.66,0.33 |
| Inventive Example 5 | ITO | NPB | CBP(host)+ 6.5%compound5 (dopant) | BCP | Alq | MgIn | 9,700 | 5.3 | 648 | 0.65,0.34 |
| Inventive Example 6 | ITO | NPB | CBP(host)+ 6.5%compound6 (dopant) | BCP | Alq | MgIn | 10,800 | 6.4 | 650 | 0.66,0.33 |
| Inventive Example 7 | ITO | NPB | CBP(host)+ 6.5%compound7 (dopant) | BCP | Alq | MgIn | 10,100 | 6.1 | 651 | 0.66,0.33 |
| Inventive Example 8 | ITO | NPB | CBP(host)+ 6.5%compound8 (dopant) | BCP | Alq | MgIn | 9,700 | 5.6 | 658 | 0.67,0.32 |
| Inventive Example 9 | ITO | NPB | CBP(host)+ 6.5%compound9 (dopant) | BCP | Alq | MgIn | 11,200 | 6.6 | 653 | 0.66,0.33 |
| Inventive Example 10 | ITO | NPB | CBP(host)+ 6.5%compound10 (dopant) | BCP | Alq | MgIn | 9,900 | 5.4 | 660 | 0.67,0.32 |
| Inventive Example 11 | ITO | NPB | CBP(host)+ 6.5%compound11 (dopant) | BCP | Alq | MgIn | 11,200 | 6.5 | 650 | 0.66,0.33 |
| Inventive Example 12 | ITO | NPB | CBP(host)+ 6.5%compound12 (dopant) | BCP | Alq | MgIn | 10,200 | 6.3 | 651 | 0.66,0.33 |
| Inventive Example 13 | ITO | NPB | CBP(host)+ 6.5%compound13 (dopant) | BCP | Alq | MgIn | 12,000 | 6.8 | 650 | 0.66,0.33 |
| Inventive Example 14 | ITO | NPB | CBP(host)+ 13%compound13 (dopant) | BCP | Alq | Mgln | 8,500 | 4.8 | 672 | 0.68,0.32 |
| Inventive Example 15 | ITO | NPB | CBP(host)+ 20%compound13 (dopant) | BCP | Alq | MgIn | 5,500 | 3.5 | 673 | 0.68,0.32 |
| Inventive Example 16 | ITO | NPB | CBP(host)+ 3%compound13 (dopant) | BCP | Alq | Mgln | 13,500 | 7 | 649 | 0.65,0.35 |

From the results shown in Table 1, it was apparent that the use of the compounds 1 to 13, which are the triplet excited materials, as the red-orange luminescent dopants of the light emitting layers realized the red-orange emission with high luminance at excellent luminous efficiency in the organic EL devices.

### [Inventive Examples 14 to 16]

In the inventive examples 14 to 16, such organic EL devices were employed that each has the same structure as that of the organic EL device in the inventive example 13 except for the concentrations of the dopants of the light emitting layers. The concentrations of the compound 13 used as the dopant were set to 13 %, 20 %, 3 %, respectively, in the organic EL devices of the inventive examples 14 to 16. The organic EL devices of the inventive examples 14 to 16 were manufactured by the same method as applied to the organic EL device of the inventive example A.

The luminescent characteristics of the above organic EL devices were measured by the same method as applied to the inventive example A. The above Table 1 shows the results of measurement of the materials and the luminescent characteristics of the organic EL devices in the inventive examples 14 to 16.

According to the inventive example 16, when the concentration of the compound 13 as the dopant was 3 %, the maximum luminance was 13, 500 cd/m² , and the luminous efficiency at this time was 7 cd/A. According to the inventive example 13, when the concentration of the compound 13 as the dopant was 6.5 %, the maximum luminance was 12,000 cd/m² and the luminous efficiency at this time was 6.8 cd/A. According to the inventive example 14, when the concentration of the compound 13 as the dopant was 13 %, the maximum luminance was 8,500 cd/m^{2,} and the luminous efficiency at this time was 4.8 cd/A. According to the inventive example 15, when the concentration of the compound 13 as the dopant was 20 %, the maximum luminance was 5,500 cd/m², and the luminous efficiency at this time was 3.5 cd/A. From the results of the inventive examples 13 to 16, it was found that excellent luminous efficiency was realized when the concentration of the compound 13 was in the range of from 3 % to 20 %.

## Claims

1. An organic electroluminescent device, comprising:
a hole injection electrode;
an electron injection electrode; and
a light emitting layer provided between said hole injection electrode and said electron injection electrode, wherein
said light emitting layer includes a compound composed of a platinum group element and a phenanthridine derivative.

2. The organic electroluminescent device according to claim 1, wherein said platinum group element is iridium, platinum, osmium, ruthenium, rhodium or palladium.

3. The organic electroluminescent device according to claim 1, wherein said compound composed of said platinum group element and said phenanthridine derivative has a molecular structure represented by a formula (1) shown below: 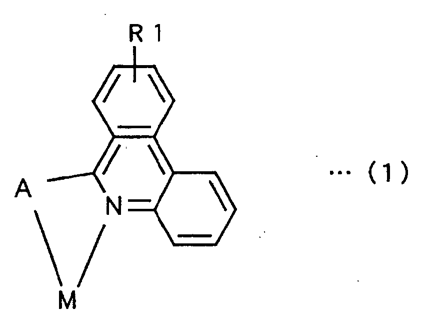 where R1 is a hydrogen atom, a halogen atom or a substituent, A is a substituent, and M is a platinum group element.

4. The organic electroluminescent device according to claim 2, wherein said A has a molecular structure represented by a formula (A1) shown below: 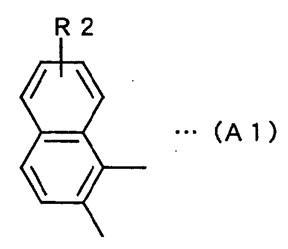 where R2 is a hydrogen atom, a halogen atom or a substituent.

5. The organic electroluminescent device according to claim 2, wherein said A has a molecular structure represented by a formula (A2) shown below: 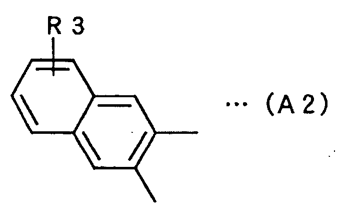 where R3 is a hydrogen atom, a halogen atom or a substituent.

6. The organic electroluminescent device according to claim 2, wherein said A has a molecular structure represented by a formula (A3) shown below: 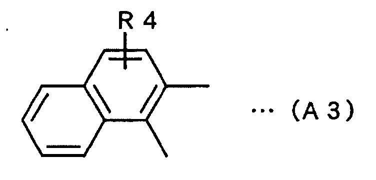 where R4 is a hydrogen atom, a halogen atom or a substituent.

7. The organic electroluminescent device according to claim 2, wherein said A has a molecular structure represented by a formula (A4) shown below: 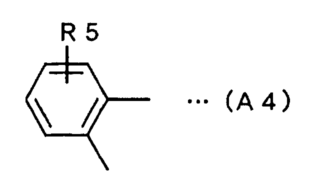 where R5 is a hydrogen atom, a halogen atom or a substituent.

8. The organic electroluminescent device according to claim 2, wherein said A has a molecular structure represented by a formula (A5) shown below: 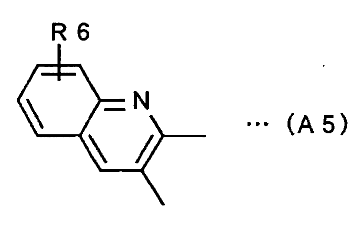 where R6 is a hydrogen atom, a halogen atom or a substituent.

9. The organic electroluminescent device according to claim 2, wherein said A has a molecular structure represented by a formula (A6) shown below: 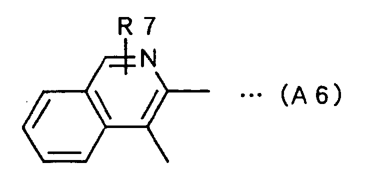 where R7 is a hydrogen atom, a halogen atom or a substituent.

10. The organic electroluminescent device according to claim 2, wherein said A has a molecular structure represented by a formula (A7) shown below: 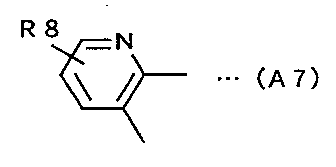 where R8 is a hydrogen atom, a halogen atom or a substituent.

11. The organic electroluminescent device according to claim 1, wherein said compound composed of said platinum group element and said phenanthridine derivative has a molecular structure represented by a formula (2) shown below: 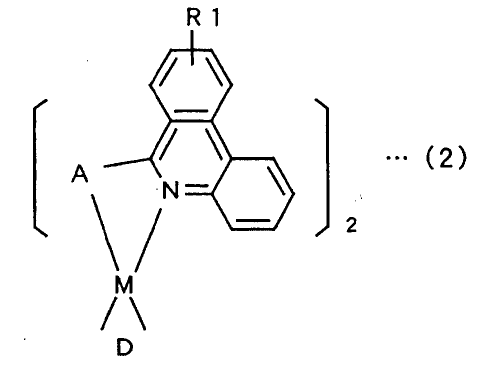 where R1 is a hydrogen atom, a halogen atom or a substituent, A is a substituent, M is a platinum group element, and D is a substituent forming a ring.

12. The organic electroluminescent device according to claim 11, wherein said D has a molecular structure represented by a formula (D1) shown below: 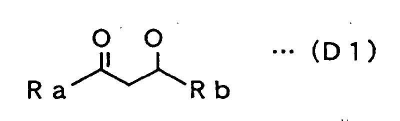 where Ra and Rb being the same or different are each a hydrogen atom, a halogen atom or a substituent.

13. The organic electroluminescent device according to claim 11, wherein said D has a molecular structure represented by a formula (D2) shown below: 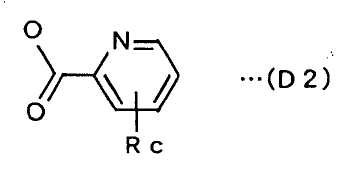 where Rc is a hydrogen atom, a halogen atom or a substituent.

14. The organic electroluminescent device according to claim 1, wherein said compound composed of said platinum group element and said phenanthridine derivative has a molecular structure represented by a formula (3) shown below: 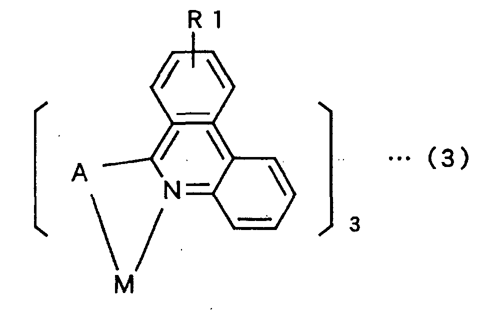 where R1 is a hydrogen atom, a halogen atom or a substituent, A is a substituent, and M is a platinum group element.

15. The organic electroluminescent device according to claim 14, wherein said compound composed of said platinum group element and said phenanthridine derivative has a molecular structure represented by a formula (C13) shown below:

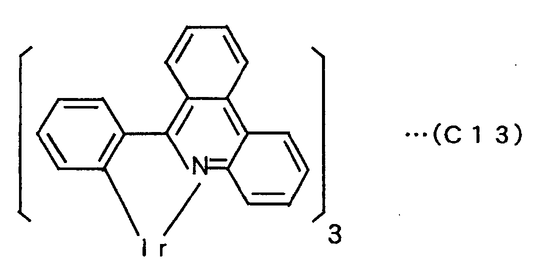

16. The organic electroluminescent device according to claim 14, wherein said compound composed of said platinum group element and said phenanthridine derivative has a molecular structure represented by a formula (C10) shown below:

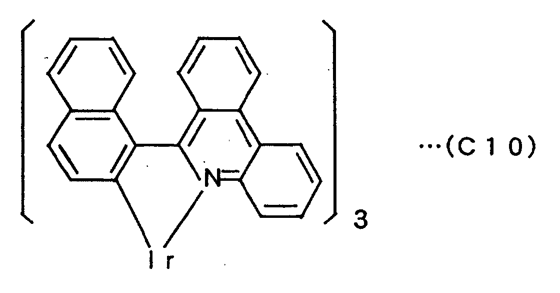

17. The organic electroluminescent device according to claim 1, wherein said light emitting layer further includes a host material, and the content of said compound composed of said platinum group element and said phenanthridine derivative is not less than 0.1 wt% nor more than 50 wt% for said host material.

18. The organic electroluminescent device according to claim 17, wherein said host material is 4,4'-bis(carbazol-9-yl)biphenyl having a molecular structure represented by a formula (12) shown below:

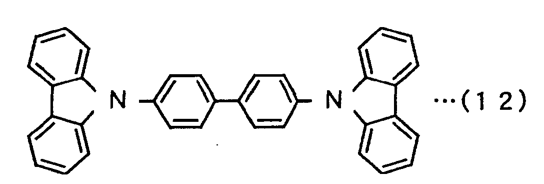

19. The organic electroluminescent device according to claim 1, further comprising an electron transport layer provided between said light emitting layer and said electron injection electrode, and
a hole blocking layer provided between said light emitting layer and said electron transport layer and having a larger ionization potential than that of said electron transport layer.

20. A light emitting material having a molecular structure represented by a formula (1) shown below: 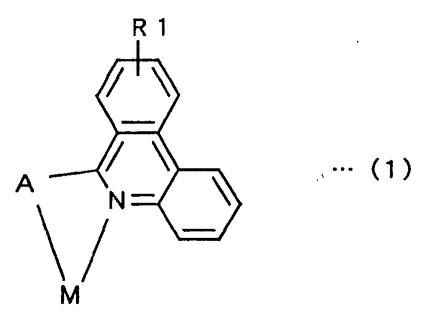 where R1 is a hydrogen atom, a halogen atom or a substituent, A is a substituent, and M is a platinum group element.

21. A light emitting material having a molecular structure represented by a formula (2) shown below: 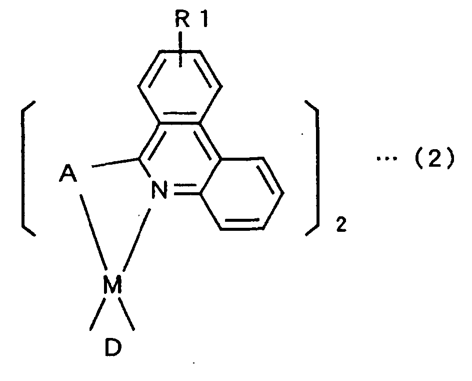 where R1 is a hydrogen atom, a halogen atom or a substituent, A is a substituent, M is a platinum group element, and D is a substituent forming a ring.

22. The light emitting material according to claim 21, wherein said D has a molecular structure represented by a formula (D1) shown below: 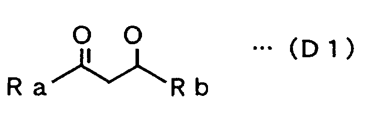 where Ra and Rb being the same or different are each a hydrogen atom, a halogen atom or a substituent.

23. The light emitting material according to claim 21, wherein said D has a molecular structure represented by a formula (D2) shown below: 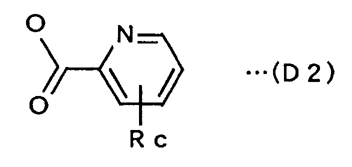 where Rc is a hydrogen atom, a halogen atom or a substituent.

24. A light emitting material having a molecular structure represented by a formula (3) shown below: 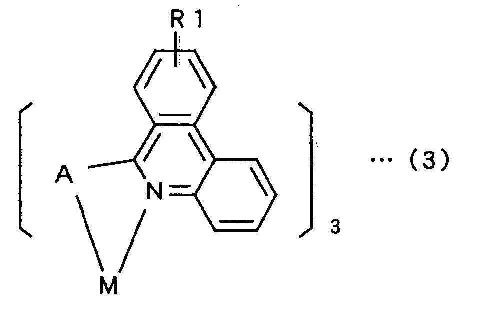 where R1 is a hydrogen atom, a halogen atom or a substituent, A is a substituent, and M is a platinum group element.

25. An organic compound having a molecular structure represented by a formula (2) shown below: 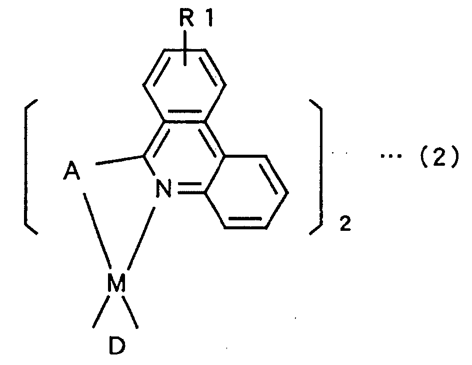 where R1 is a hydrogen atom, a halogen atom or a substituent, A is a substituent, M is a platinum group element, and D is a substituent forming a ring.

26. The organic compound according to claim 25, wherein said D has a molecular structure represented by a formula (D1) shown below: 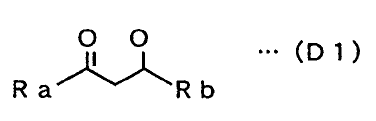 where Ra and Rb being the same or different are each a hydrogen atom, a halogen atom or a substituent.

27. The organic compound according to claim 25, wherein said D has a molecular structure represented by a formula (D2) shown below: 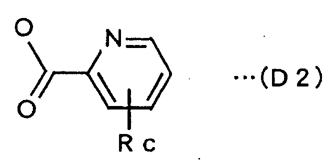 where Rc is a hydrogen atom, a halogen atom or a substituent.

28. An organic compound having a molecular structure represented by a formula (3) shown below: 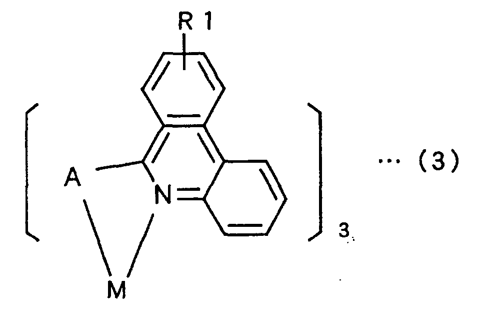 where R1 is a hydrogen atom, a halogen atom or a substituent, A is a substituent, and M is a platinum group element.

29. An organic compound having a molecular structure represented by a formula (C1) shown below:

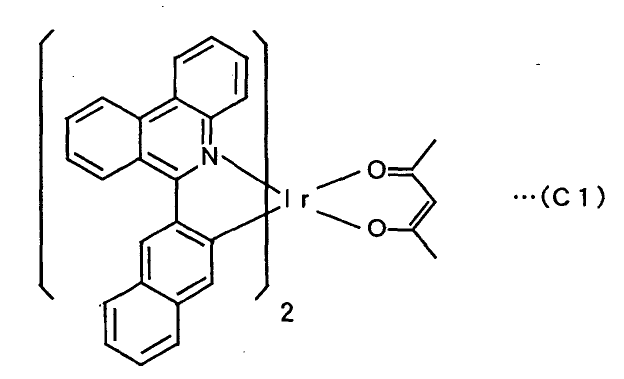

30. An organic compound having a molecular structure represented by a formula (C2) shown below:

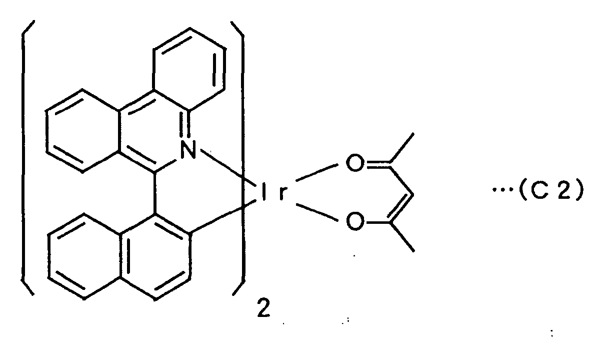

31. An organic compound having a molecular structure represented by a formula (C3) shown below:

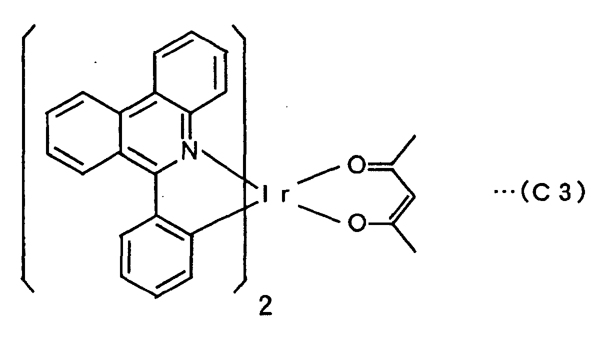

32. An organic compound having a molecular structure represented by a formula (C4) shown below:

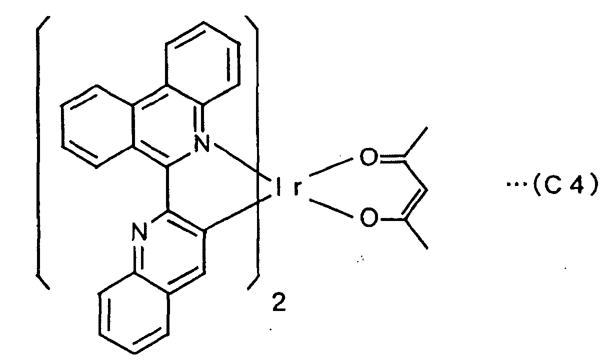

33. An organic compound having a molecular structure represented by a formula (C5) shown below:

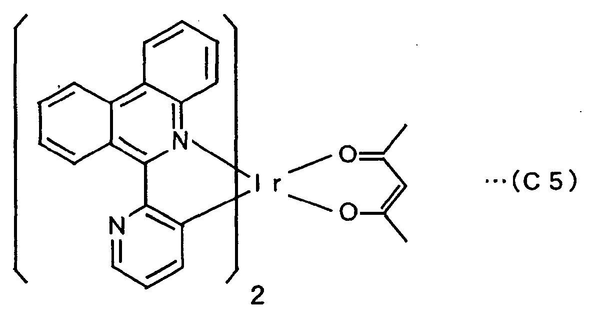

34. An organic compound having a molecular structure represented by a formula (C6) shown below:

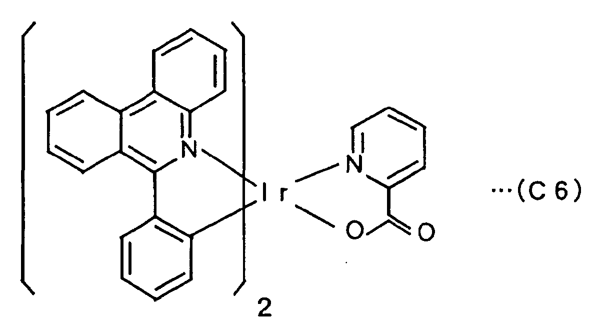

35. An organic compound having a molecular structure represented by a formula (C7) shown below:

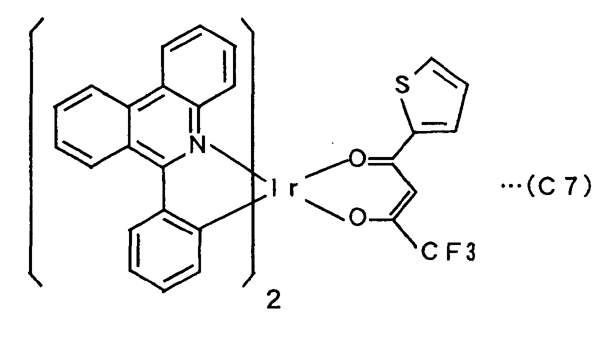

36. An organic compound having a molecular structure represented by a formula (C8) shown below:

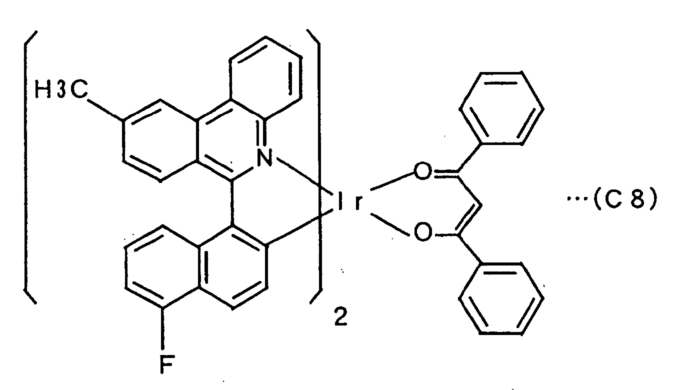

37. An organic compound having a molecular structure represented by a formula (C9) shown below:

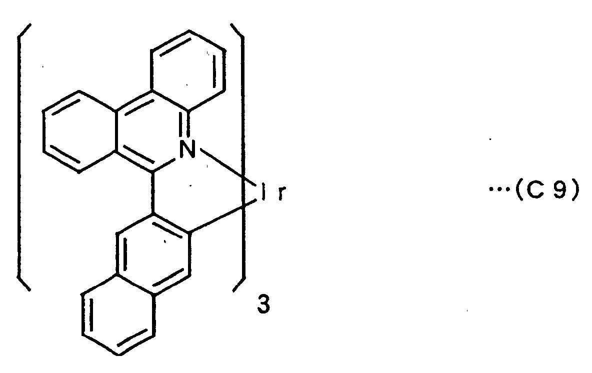

38. An organic compound having a molecular structure represented by a formula (C10) shown below:

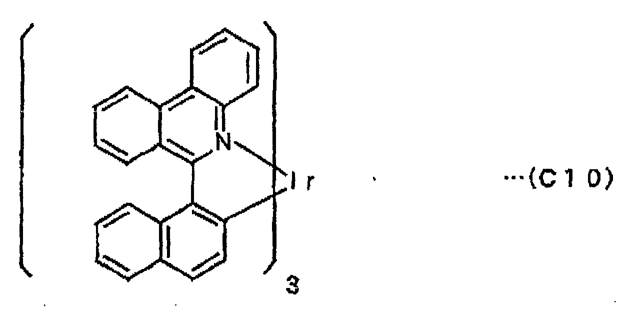

39. An organic compound having a molecular structure represented by a formula (C11) shown below:

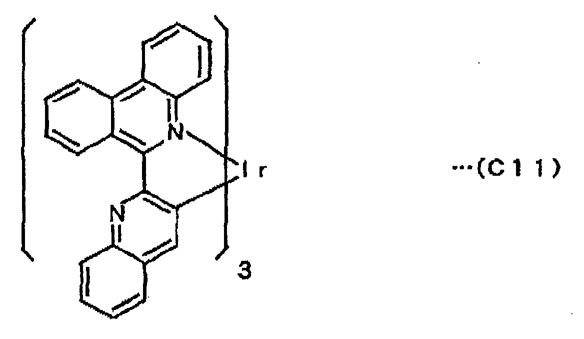

40. An organic compound having a molecular structure represented by a formula (C12) shown below:

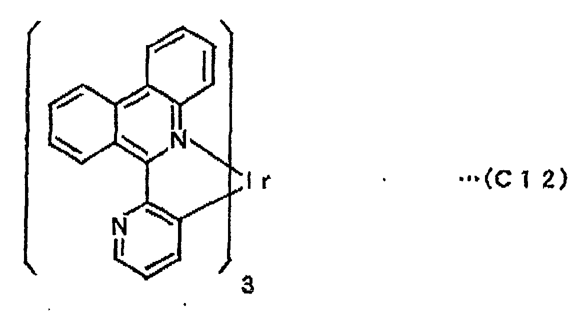

41. An organic compound having a molecular structure represented by a formula (C13) shown below:
